# EUROPÄISCHE PATENTSCHRIFT

(11) **EP 3 649 388 B1**
(45) Veröffentlichungstag und Bekanntmachung des Hinweises auf die Patenterteilung: **14.09.2022**
(21) Anmeldenummer: 19729718.7
(22) Anmeldetag: 06.06.2019
(51) Int. Cl.: F16K 31/124, F15B 13/04, F15B 19/00, F16K 31/00, H01L 41/09, F16K 37/00, F15B 13/043

(54) **SICHERHEITSVENTIL**
SAFETY VALVE
VANNE DE SÉCURITÉ

(30) Priorität: 11.06.2018 DE 102018113846; 11.06.2018 DE 202018103257 U
(43) Veröffentlichungstag der Anmeldung: 13.05.2020
(73) Patentinhaber: HOERBIGER Flow Control GmbH, 86972 Altenstadt (DE)
(72) Erfinder: SCHAIBLE, Jochen, 72213 Altensteig (DE); HALLER, Daniel, 70569 Stuttgart (DE); NEISS, Sebastian, 70197 Stuttgart (DE)
(74) Vertreter: Grättinger Möhring von Poschinger Patentanwälte Partnerschaft mbB
(86) Internationale Anmeldenummer: PCT/EP2019/064760
(87) Internationale Veröffentlichungsnummer: WO 2019/238519

(56) Entgegenhaltungen:
- WO-A1-98/02685
- WO-A1-2017/178272
- DE-A1-102016 213 228

## Beschreibung

Die vorliegende Erfindung betrifft ein Sicherheitsventil mit einer elektronischen Steuereinheit zur Erzeugung einer Steuerspannung, einer elektro-fluidischen Vorstufe, welche einen mittels der Steuerspannung zwischen einer Arbeits- und einer Sicherheitsstellung betätigbaren Piezobiegewandler aufweist, wobei der Piezobiegewandler stellungsabhängig den Fluss eines sekundären Steuerfluidstroms beeinflusst, und einer fluid-mechanischen Hauptstufe mit einer Beeinflussungseinrichtung zur Beeinflussung des Flusses eines primären Arbeitsfluidstroms, wobei die Beeinflussungseinrichtung mittels des in einen Steuerraum der Hauptstufe mündenden sekundären Steuerfluidstroms betätigbar ist.

Derartige zweistufige Sicherheitsventile sind aus dem Stand der Technik, z.B. aus der WO 98/02685 A, hinlänglich bekannt. Sie eignen sich in besonderer Weise zur besonders effizienten und präzisen Betätigung fluidischer Schalt-, Steuer- und Regelgeräte und können insbesondere modular aufgebaut sein. Dabei hat sich insbesondere die Aufteilung des fluidischen Medienstroms in einen für die Betätigung der Hauptstufe zuständigen sekundären Steuerfluidstrom sowie einen primären Arbeitsfluidstrom bewährt. Jedem dieser Fluid- bzw. Medienströme ist dabei je eine Beeinflussungseinrichtung (Ventil) zugeordnet. Bei einem der vorliegenden Erfindung zugrundeliegenden gattungsgemäßen Sicherheitsventil wird die Beeinflussungseinrichtung der Vorstufe durch einen Piezobiegewandler gebildet, der - direkt oder indirekt als Aktuator für ein separates Ventilelement - den sekundären Steuerfluidstrom in Richtung zum Steuerraum der nachgelagerten Hauptstufe steuert. Bei der Beeinflussungseinrichtung der Hauptstufe handelt es sich vorteilhaft um ein fluidisch betätigtes Ventilelement, mit dem auf geeignete Weise der Fluss eines primären Arbeitsfluidstroms gesteuert wird.

Diese beiden Beeinflussungseinrichtungen unterscheiden sich zunächst hinsichtlich der Art der ihnen jeweils zugeführten Betätigungsenergie, indem die Beeinflussungseinrichtung der Vorstufe elektrisch und die Beeinflussungseinrichtung der Hauptstufe fluidisch (durch das sekundäre Steuerfluid) betätigt wird.

Durch geeignete Wahl des Energieübersetzungsverhältnisses zwischen Vor- und Hauptstufe wird es damit möglich, einen hochenergetischen primären Arbeitsfluidstrom mittels eines deutlich niederenergetischeren elektrischen Steuersignals (Steuerspannung) zu beeinflussen. Die notwendige Energiedifferenz zur Betätigung der Beeinflussungseinrichtung der Hauptstufe wird dabei durch das - abhängig vom Schaltzustand des Piezobiegewandlers der Vorstufe auf geeignete Weise zum Steuerraum der Hauptstufe geführte bzw. gesperrte - Druckmedium des Sekundärfluidstroms aufgebracht.

Ein besonderer Vorteil derartig fluidisch vorgesteuerter Systeme liegt somit darin, dass das aus Steuereinheit und Vorstufe bestehende elektro-fluidische Interface, unabhängig vom tatsächlichen Energiebedarf der Hauptstufe zur Beeinflussung des primären Arbeitsfluidstroms, ausschließlich die eingeschränkte elektrische Betätigungsenergie zur Beeinflussung des sekundären Steuerfluidstroms bereitzustellen braucht.

Ein solches elektro-fluidisches Interface kann grundsätzlich auf unterschiedlichsten elektro-mechanischen Wandlerprinzipien beruhen (z.B. elektromechanisch, magnetostriktiv, elektrothermisch, elektro-rheologisch, kapazitiv, piezoelektrisch, etc.). Für den industriellen Einsatz haben sich bislang insbesondere elektromagnetische und piezoelektrische Aktuatormechanismen für die Vorstufe bewährt. Bezüglich der Energieeffizienz erweisen sich letztere als besonders vorteilhaft, so dass die vorliegende Erfindung hierauf basiert.

Als piezoelektrische Aktuatoren in Einsatzfeldern, welche hohe Betätigungswege sowie die Bereitstellung einer hohen Mindestaktuatorkraft verlangen, haben sich insbesondere sogenannte Piezobiegewandler mit streifen- oder plattenförmigem piezoelektrisch aktivem Material bewährt, das kraftschlüssig auf einer flächig ausgeführten piezoelektrisch inaktiven Trägerschicht geringer Kompressibilität angeordnet ist. Die durch elektrische Anregung des piezoelektrisch aktiven Materials in diesem induzierte und reversible Gestaltänderung führt, in Wechselwirkung mit der kraftschlüssig verbundenen Trägerschicht geringer Kompressibilität, zur geometrischen Durchbiegung des Piezobiegewandlers, der somit durch Anlegen einer Steuerspannung aus einer (typischerweise die Sicherheitsstellung darstellenden) Ruhestellung in eine (typischerweise die Arbeitsstellung darstellende) ausgelenkte Stellung überführt werden kann. Zur optimalen Leistungsausnutzung werden flächige Piezobiegewandler in der Regel länglich und schmal ausgeführt. Die Kraftausleitung erfolgt dabei typischerweise entlang der Längsrichtung des Piezobiegewandlers, wobei dessen kurz ausgeführte Quererstreckung den Kraftaufbau unterstützt.

Piezoelektrische Materialien unterliegen hinsichtlich ihres Volumen-/Formänderungsvermögens physikalisch engen Grenzen. Typischerweise lassen sich unter den gegebenen Bedingungen in piezo-elektrischen aktiven Hochleistungswerkstoffen Dehnungen induzieren, welche unterhalb von 1/10.000 der Ruheabmessung liegen. Dies erfordert im Rahmen der Herstellung von Piezobiegewandlern herstellungsseitig ein Höchstmaß an Präzision. Bereits geringfügige Fehler in der Kristallstruktur des piezoelektrisch aktiven Materials und/oder der geometrischen Abmessung bzw. im Schichtaufbau des Piezobiegewandlers können dazu führen, dass sich entsprechende Biegewandler nicht mit der notwendigen Sicherheit zum (Dauer-)Einsatz in sicherheitskritischen Anwendungen eignen. Nachdem piezoelektrische Materialen außerdem vergleichsweise hohe Werkstoffkosten aufweisen, gebietet sich bereits aus wirtschaftlichen Gründen ein entsprechend sorgsamer Umgang mit den zur Verwendung kommenden Materialien.

Vor diesem Hintergrund erklärt sich im Übrigen, dass piezoelektrische Serienprodukte generell mit limitierten Leistungsreserven zurechtkommen müssen, d.h. dass sich insbesondere Piezobiegewandler in gattungsgemäßen Sicherheitsventilen häufig am Rande der herstellungstechnisch machbaren Leistungsgrenzen bewegen.

Zur Absicherung der benötigten Produkteigenschaften erweisen sich bisher zwei Strategien als besonders erfolgsversprechend.

Eine erste Strategie setzt herstellungsseitig auf eine Minimierung sämtlicher Faktoren die zu Leistungsverlusten führen können, insbesondere durch den Einsatz von Präzisionsverfahren und geeigneten Qualitätssicherungsmaßnahmen über die gesamte Fertigungsprozesskette, so dass im Rahmen der Herstellung von bestimmte Leistungskriterien erfüllenden Piezobiegewandlern möglichst wenig Ausschuss entsteht. Da im Rahmen der Qualitätssicherung auch einbezogen werden muss, dass gattungsgemäße Sicherheitsventile und deren Piezobiegewandler ggfs. auch unter extremen Umgebungsbedingungen (z.B. am Rande eines geeignet vorzugebenden Sollbetriebsbereichs) eingesetzt werden können und da sich im Dauerbetrieb je nach Umgebungsbedingungen (z.B. temperaur- und/oder atmosphärenabhängig) ggfs. unterschiedlich stark ausgeprägte Relaxations- oder Alterungseffekte ergeben können, kann trotz sorgfältigster Herstellungsmethoden derzeit ein bestimmtes Maß an Produktionsausschuss nicht vermieden werden.

Eine zweite Strategie bemüht sich um einen Individualausgleich fertigungs- und/oder verschleißbedingter Leistungseinschränkungen durch produktinterne Zustandsdiagnose sowie deren vorzugsweise elektrische Kompensation, indem z.B. Piezobiegewandler bzw. die den Piezobiegewandler enthaltenden Vorstufen mit zusätzlicher Sensorik ausgestattet werden, wie dies z.B. aus der DE 10 2016 213 228 A2 bekannt ist.

Generell können mit beiden vorgenannten Strategien bzw. deren Kombination die technischen Leistungsgrenzen über ein breites Anwendungsfeld ausgeschöpft werden.

Die erste Strategie erfordert einen erhöhten Investitionsaufwand in Fertigungs- und Qualitätssicherungsverfahren und Prozesse, wobei trotz sorgfältigster Produktionsverfahren ein teils nicht unerheblicher Produktionsausschuss letztlich nicht vermeidbar ist, insbesondere wenn - wie dies für gattungsgemäße Sicherheitsventile regelmäßig der Fall ist - ein hohes Maß an Ausfallsicherheit gewährleistet werden soll.

Demgegenüber erhöht sich bei der zweiten Strategie der produktbezogene Herstellungskostenaufwand erheblich, da hierfür der Einsatz zusätzlicher Sensorik, Datenspeicher oder auch Auswerteeinrichtungen in den Vorstufen von gattungsgemäßen Sicherheitsventilen erforderlich wird. Somit entsteht oft ein diametraler Widerspruch zum Produktansatz minimalisierter und auf das notwendigste reduzierter Lösungen.

Vor diesem Hintergrund ist es die Aufgabe der vorliegenden Erfindung, ein gattungsgemäßes und möglichst universell einsetzbares Sicherheitsventil der eingangs genannten Art so zu verbessern, dass sich durch eine vergleichsweise einfach zu implementierende Sicherfunktion dessen Zuverlässigkeit im Betrieb erhöht wird.

Diese Aufgabe wird mit einem Sicherheitsventil nach Anspruch 1 gelöst. Dieses zeichnet sich neben den eingangs genannten Merkmalen dadurch aus, dass die Steuereinheit zur vollautomatischen und nach Ablauf vorgegebener Zeitintervalle iterativ zu wiederholenden Durchführung eines Funktionstests der elektro-fluidischen Vorstufe eingerichtet ist, wobei im Rahmen des Funktionstests unter geeigneter Variation der Steuerspannung eine derart kurzzeitige und/oder derart geringfügige Veränderung der Stellung des Piezobiegewandlers herbeigeführt wird, dass zwar einerseits unter gleichzeitig erfolgender Ermittlung einer tatsächlich erfolgenden Auslenkungsbewegung des Piezobiegewandlers dessen korrekte Funktionsweise überprüfbar ist, jedoch andererseits keinerlei Beeinflussung des Flusses des primären Arbeitsfluidstroms durch die Hauptstufe erfolgt.

Mit der vorliegenden Erfindung lassen sich selbst für sicherheitskritische Anwendungen auch solche Piezobiegewandler in einem erfindungsgemäßen Sicherheitsventil einsetzen, die aufgrund geringfügiger Abweichungen von den herstellungstechnisch gewünschten Normparametern bisher als Ausschuss galten, da sie sich am Rande der für die Sicherstellung eines Dauerbetriebs zu gewährleistenden Produkteigenschaften befanden. Denn ein erfindungsgemäßes Sicherheitsventil kann aufgrund der erfindungsgemäß implementierten Funktionstests stets gewährleisten, dass der als Aktor der Vorstufe dienende Piezobiegewandler entweder korrekt funktioniert oder dass eine ggfs. bestehende oder bevorstehende Funktionsstörung auf Seiten des Piezobiegewandlers erkannt wird, womit entsprechende Gegenmaßnahmen (z.B. Austausch der Vorstufe eines erfindungsgemäßen Sicherheitsventils oder des Sicherheitsventils insgesamt) ergriffen werden können.

Sollten sich bei einem oder mehreren der Funktionstests relevante Abweichungen von der Sollfunktionsweise des Piezobiegewandlers ergeben, die z.B. insbesondere auch in einer schleichenden Veränderung/Verschlechterung der Funktionsfähigkeit des Piezobiegewandlers bestehen können, so kann das Bedienpersonal durch ein geeignet auszugebendes Alarm- bzw. Fehlersignal darauf hingewiesen werden, dass eine korrekte Funktionsweise des Sicherheitsventils nicht mehr gegeben ist oder ggfs. bald nicht mehr gegeben sein wird. Ferner kann durch entsprechende Datenspeicherung der Messergebnisse der iterativ durchgeführten Funktionstests bei Bedarf auch dokumentiert werden, dass die Vorstufe des Sicherheitsventils bzw. der darin verbaute Piezobiegewandler sich noch in einwandfreiem Zustand befindet.

Soweit vorstehend davon gesprochen wird, dass im Rahmen der erfindungsgemäß zu wiederholenden Funktionstests eine Aussage zur korrekten Funktionsweise des Piezobiegewandlers getroffen wird, so wird hierbei insbesondere durch geeignete Messung überprüft, ob die durch Variation der Steuerspannung zu erwartende Auslenkungsbewegung des Piezobiegewandlers innerhalb eines vorgegebenen Normbereichs liegt. Eine Messung des realen Bewegungsverhaltens bzw. einer tatsächlich erfolgenden Auslenkungsbewegung des Piezobiegewandlers lässt sich im Rahmen der vorliegenden Erfindung, wie dies nachfolgend noch näher erläutert wird, in besonders bevorzugter Weise mittels der im piezo-elektrisch aktiven Material natürlich vorhandenen sensorischen Eigenschaften ohne zusätzliche Sensorik in der den Piezobiegewandler aufweisenden Vorstufe realisieren, was herstellungstechnisch von großem Vorteil ist.

Grundsätzlich sei im Rahmen der vorliegenden Erfindung noch erwähnt, dass eine Implementierung von iterativ zu wiederholenden Funktionstests bei Sicherheitsventilen grundsätzlich bereits bekannt ist. Dabei handelt es sich jedoch zumeist, wie z.B. im Stand der Technik gemäß WO 01/59346 A1, WO 2008/005967 A2 oder WO 2016/149590 A1, um so genannte "Partial Stroke Tests" bzw. "Teilhubtests", mit denen stets die Funktionalität des Sicherheitsventils insgesamt unter Beeinflussung des primären Arbeitsfluidstroms überprüft wird. Ferner ist aus der WO 2008/000459 A1 bereits eine Strömungsmaschine mit mehreren als Aktuatoren dienenden Prozessstellelementen bekannt, bei dem die Funktionsweise eines ersten Prozessstellelements ohne Einfluss auf die nachgeschaltete Prozessgröße überprüft wird, indem während des Funktionstests beide Prozessstellelemente derart gegensinnig zueinander verstellt werden, dass sich die Einflüsse der Verstellungen auf die nachgeschaltete Prozessgröße im Wesentlichen aufheben, was bei einem Sicherheitsventil der vorliegend beanspruchten Art mit nur einem als Aktuator fungierenden Piezobiegewandler nicht möglich wäre.

In einer ersten vorteilhaften Ausführungsvariante der Erfindung kann insbesondere vorgesehen sein, dass die Beeinflussungseinrichtung der fluid-mechanischen Hauptstufe durch geeignete Vorgabe des Volumens des Steuerraums, der gegebenen Druckverhältnisse und/oder der zu ihrer Betätigung benötigten Energie nur mit einer so großen Zeitverzögerung durch das in den Steuerraum einströmende sekundäre Steuerfluid betätigt wird, dass der Piezobiegewandler im Rahmen des Funktionstests durch kurzzeitige Abschaltung der Steuerspannung aus seiner Arbeitsstellung in seine Sicherheitsstellung und wieder zurück bewegt werden kann, ohne dass sich dabei eine Beeinflussung des Flusses des primären Arbeitsfluidstroms durch die Hauptstufe ergibt.

Mit anderen Worten kann das erfindungsgemäße Sicherheitsventil also vorteilhaft so ausgeführt sein, dass die jeweiligen Schalt- bzw. Reaktionszeiten der Vor- und Hauptstufe so bemessen sind, dass sich der Piezobiegewandler im Rahmen eines Funktionstests so schnell (vollständig) aus seiner Arbeits- in seine Sicherheitsstellung und wieder zurück schalten lässt, dass die hierfür benötigte Zeitspanne kleiner ist als die vorgegebene Zeitverzögerung der Hauptstufe, so dass die Hauptstufe bzw. deren Beeinflussungseinrichtung durch den kurzzeitigen Wechsel der Schaltstellung des Piezobiegewandler nicht betätigt wird, und im Ergebnis keine Beeinflussung des primären Arbeitsfluids durch das Sicherheitsventil erfolgt.

In einer zweiten Ausführungsvariante kann vorgesehen sein, dass der Piezobiegewandler während des Funktionstests durch geeignete Absenkung der Steuerspannung nur geringfügig aus seiner Arbeitsstellung ausgelenkt wird, und zwar insbesondere auf eine solche Art und Weise, dass der hierdurch gegebene Einfluss auf den Druck im Steuerraum der Hauptstufe so gering bleibt, dass sich selbst bei Erreichen oder Überschreiten der Zeitverzögerung der Hauptstufe noch keine den Fluss des primären Arbeitsfluid beeinflussende Betätigung der Beeinflussungseinrichtung der Hauptstufe ergibt. Auch auf diese Weise kann bei gleichzeitig erfolgender Erfassung der tatsächlichen Auslenkungsbewegung des Piezobiegewandlers der im Rahmen des Funktionstests benötigte Rückschluss auf die korrekte Funktionsweise des Piezobiegewandlers bzw. der Vorstufe gezogen werden, ohne dabei die Hauptstufe bzw. deren Beeinflussungseinrichtung zu betätigen.

Grundsätzlich ist zur vorliegenden Erfindung noch anzumerken, dass ein erfindungsgemäßes Sicherheitsventil abhängig von der jeweiligen Kundenanforderung in seiner konkreten Ausgestaltung stark variieren und unterschiedliche Komplexität besitzen kann.

Es ist grundsätzlich so ausgeführt, dass es eine Medientrennung zwischen dem sekundären Steuerfluidstrom und dem primären Arbeitsfluidstrom ermöglicht. Hierüber wird erreicht, dass Primär- und Sekundärfluid weder in Art, Durchfluss oder Druck identisch zu sein brauchen. Durch geeignete Auslegung lassen sich so über den bevorzugt energieoptimierten sekundären Steuerfluidstrom energetisch stark abweichende Primärfluidströme steuern.

Die Aufteilung der fluidischen Betätigungseinrichtung in Vor- und Hauptstufe erlaubt in einer Art Baukastensystem die Kombination einer identisch ausgestalteten elektronischen Steuereinheit und einer identischen (mit einem Piezobiegewandler ausgestatteten) Vorstufe mit einer anwendungsbezogen geeignet wählbaren Hauptstufe, insbesondere im Hinblick auf die Grundfunktionalität eines als Beeinflussungseinrichtung der Hauptstufe fungierenden Arbeitsventils. Durch die flexible Systemkonfiguration mit einer unbetätigt geöffneten (NO) oder aber einer unbetätigt geschlossenen (NG) Beeinflussungseinrichtung der Hauptstufe kann dem Gesamtaufbau (in Zusammenwirkung mit der vorgegebenen Arbeits- und Sicherheitsstellung des Piezobiegewandlers) ein definiertes Sicherheitsverhalten bei Ausfall des elektrischen oder fluidischen Energieträgers eingeprägt werden. Dies ist insbesondere beim Einsatz in sicherheitsrelevanten Anwendungen entscheidend, welche im Fehlerfall ohne zusätzliche Hilfsenergie einen definiert sicheren Zustand einnehmen müssen.

Wie im Stand der Technik können somit erfindungsgemäße Sicherheitsventile im Normalbetrieb als dauerbetätigte Umschaltventile eingesetzt werden, welche im Sicherheitsfall in die gewünschte Sicherheitsstellung zurücckehren. Mit der vorliegenden Erfindung verbessern sich die Sicherheitskennwerte derartiger Ventile nachhaltig. Dies wird insbesondere dadurch erreicht, dass die erfindungsgemäß implementierten Funktionstests am betätigten Sicherheitsventil im Betrieb durchgeführt werden können, wobei es während jedes der iterativen Funktionstests weder zur Prozessbeeinträchtigung noch zur zeitweisen Außerkraftsetzung der Sicherheitseinrichtung kommt.

Bei Verwendung des beschriebenen zweistufigen Ventilaufbaus aus einer den Piezobiegewandler aufweisenden Vorstufe (mit bevorzugt kurzer Schaltzeit) in Kombination mit der nachgelagerten Hauptstufe (mit Schaltverzögerung), lässt sich durch geeignete Auslegung des beide Stufen verbindenden Volumen-/Druckverhältnisses ein stabiler zeitabhängiger Übergangsbereich erzeugen, in dem kurzzeitige Schwankungen des den Piezobiegewandler betätigenden Steuerstroms ohne Auswirkung auf die Hauptstufe bzw. den hiervon beeinflussten Primärfluidstrom bleiben.

Die während der Funktionstests für Diagnosezwecke nutzbare maximale Zeitspanne des zeitlichen Übergangsbereichs berechnet sich aus der Dauer des während des Funktionstests vorzunehmenden Umschaltvorgangs der Vorstufe und der Zeitverzögerung, mit der die nachgelagerte Arbeitsstufe einer Veränderung des Eingangssignals folgt. Dieser Übergangsbereich bildet den direkten Zusammenhang zwischen dem zugeführten sekundären Steuerfluidstrom, dem Totvolumen des Steuerraums der Hauptstufe sowie der notwendigen Betätigungsenergie zur Manipulation der Beeinflussungseinrichtung der Hauptstufe. Die beiden letztgenannten Kenngrößen stehen ihrerseits wieder im Zusammenhang mit dem fluidischen Übersetzungsverhältnis zwischen den getrennten Primär- und Sekundärfluidströmen. Als genereller Zusammenhang gilt, dass sich mit zunehmendem fluidischem Übersetzungsverhältnis auch der zeitliche Übergangsbereich vergrößert, was im Rahmen der vorliegenden Erfindung geeignete Berücksichtigung finden kann.

Im Rahmen der vorliegenden Erfindung kann in besonders bevorzugter Art und Weise ein modulartiger Aufbau des Sicherheitsventils vorgesehen sein, bei welchem die elektronische Steuereinheit, die elektro-fluidische Vorstufe und/oder die fluid-mechanische Hauptstufe jeweils als separate Module ausgeführt sind. Dabei muss dann lediglich die Steuereinheit auf geeignete Weise mit der Vorstufe bzw. dem darin enthaltenen Piezobiegewandler elektrisch kontaktiert werden und ein geeigneter Fluidpfad für das von der Vorstufe zum Steuerraum der Hauptstufe zu leitende sekundäre Steuerfluid bereitgestellt werden. Jedes Modul besitzt dabei vorzugsweise ein eigenes Gehäuse, die bei Zusammenbau des erfindungsgemäßen Sicherheitsventils bevorzugt benachbart zueinander angeordnet werden. Der Fluidpfad zur fluidleitenden Verbindung der Vorstufe mit der Hauptstufe kann dann vorteilhaft mittels zueinander korrespondierender Gehäusedurchbrechungen gebildet werden.

Ferner erweist es sich als besonders vorteilhaft, wenn die elektro-fluidische Vorstufe mit Ausnahme der zur Versorgung des Piezobiegewandlers mit der Steuerspannung notwendigen elektrischen Leiter keine sonstigen elektrischen und/oder elektronischen Komponenten enthält, womit insbesondere die Stückkosten erfindungsgemäßer Sicherheitsventile in vertretbarem Rahmen gehalten werden können.

Weiterhin kann in bevorzugter Ausgestaltung der vorliegenden Erfindung vorgesehen sein, dass die Steuereinheit dazu eingerichtet ist, dem Piezobiegewandler während des Funktionstests zu Diagnosezwecken über die auch die Steuerspannung führenden Leiter ein auswertbares elektrisches Messsignal, insbesondere eine Wechselspannung mit geeigneter Amplitude, aufzumodulieren. Dabei kann dann vorteilhaft ferner vorgesehen sein, dass die Steuereinheit zur Erfassung und Auswertung eines durch das Messsignal verursachten Antwortsignals eingerichtet ist, um so eine tatsächlich erfolgte Auslenkungsbewegung des Piezobiegewandlers zu ermitteln.

Bei dem Messignal kann es sich dabei vorteilhaft um eine Wechselspannung handeln, so dass unter Auswertung der Phasenverschiebung zwischen dem Messignal und des hierdurch als Antwortsignal induzierten Wechselstroms eine Impedanzänderung des Piezobiegewandlers ermittelbar ist, die zu einer tatsächlichen Auslenkungsbewegung des Piezobiegewandlers korrespondiert.

Dieser bevorzugten Ausgestaltung der vorliegenden Erfindung liegen folgende Überlegungen zugrunde: Ein Piezobiegewandler verändert beim Entfernen oder Annähern an einen mechanischen Berührpunkt im Vergleich zu frei beweglichen Zwischenpositionen seine Impedanz. Zu Diagnosezwecken kann somit dem Piezobiegewandler insbesondere eine in ihrer Amplitude (weit) unterhalb der zur Auslenkung des Piezobiegewandlers erforderlichen Schwellspannung liegende Wechselspannung aufmoduliert und zeitgleich das für die Auslenkung zuständige Gleichspannungssignal (Steuerspannung) reduziert werden. Die Änderung der Phasenverschiebung zwischen dem Verlauf der Wechselspannung und dem hierdurch induzierten Wechselstrom gestattet dann auf besonders einfache Weise und ohne dass es hierfür zusätzlicher Sensorik in der Vorstufe bedarf den zweifelsfreien Nachweis einer am Piezobiegewandler real stattgefundenen Auslenkungsbewegung bzw. erlaubt somit eine Aussage dahingehend, zu welchem Zeitpunkt der Piezobiegewandler die (typischerweise durch Anschläge vorgegebene) Arbeits- und/oder die Sicherheitsstellung einnimmt bzw. verlässt.

Nach erfolgter (kurzzeitiger) Absenkung oder Ausschaltung der Steuerspannung und vor Erreichen der kritischen Zeitverzögerung der Beeinflussungseinrichtung der Hauptstufe wird das die Vorstufe bildende Pilotventil anschließend erneut mit der zur Einnahme der Arbeitsstellung erforderlichen Steuerspannung beaufschlagt und das Sicherheitsventil somit ohne Rückwirkung auf die Hauptstufe bzw. den hierdurch beeinflussten primären Arbeitsfluidstrom in den Sollbetriebsmodus zurückgesetzt.

Im Rahmen der vorliegenden Erfindung kann jedoch selbstverständlich auch auf andere Messverfahren zur Ermittlung einer tatsächlich erfolgten Auslenkungsbewegung des Piezobiegewandlers zurückgegriffen werden, wobei insbesondere auch eine Messung der Kapazität und/oder einer Veränderung des Resonanzverhaltens des Piezobiegewandlers in Frage kommt, was ebenfalls ohne Zuhilfenahme zusätzlicher Sensorelemente in der Vorstufe möglich ist. Selbstverständlich könnten grundsätzlich auch andere elektrisch messbare, lageabhängig veränderliche Einflussgrößen auf einfache Weise zur Ermittlung einer tatsächlichen Auslenkungsbewegung des Piezobiegewandlers ausgewertet werden.

In abermals bevorzugter Weiterbildung der vorliegenden Erfindung kann vorgesehen sein, dass die Steuereinheit ferner dazu eingerichtet ist, die Länge des Zeitintervalls zwischen zwei Funktionstests in Abhängigkeit von einem die Güte des Piezobiegewandlers repräsentierenden Gütewert zu bestimmen, welcher seinerseits in einer vorzugsweise der Steuereinheit zugeordneten (also bevorzugt innerhalb der Steuereinheit angeordneten) Speichereinheit hinterlegt ist.

Bei diesem Gütewert kann es sich beispielsweise um einen im Rahmen der Qualitätskontrolle oder bei einem Kalibrierungsvorgang ermittelte Messgröße zur Qualität des in Rede stehenden Piezobiegewandlers handeln, so dass für einen qualitativ hochwertigen Biegewandler beispielsweise längere Zeitintervalle zwischen zwei aufeinanderfolgenden Funktionstests und für einen demgegenüber qualitativ schlechteren Biegewandler kürzere Zeitintervalle zwischen je zwei Funktionstests vorgebbar sind. Typische Zeitintervalle zwischen zwei Funktionstests können im Rahmen der vorliegenden Erfindung im Übrigen vorteilhaft im Bereich zwischen 8 Stunden und 72 Stunden liegen.

Weiterhin ist es dann von Vorteil, wenn die Steuereinheit dazu eingerichtet ist, den Gütewert (und die sich hieraus ergebende Länge des Zeitintervalls zwischen zwei Funktionstests) in Abhängigkeit von Messwerten vorangegangener Funktionstests dynamisch anzupassen.

So kann z.B. das Zeitintervall zwischen zwei Funktionstests verkürzt werden, wenn sich bei einem oder mehreren zuvor durchgeführten Funktionstests ergibt, dass sich die zum Halten des Piezobiegewandlers in der Arbeitsstellung notwendige Steuerspannung erhöht hat bzw. - gleichbedeutend - dass ausgehend von der Arbeitsstellung bereits eine geringere Absenkung der Steuerspannung ausreicht, damit sich der Piezobiegewandler aus der Arbeitsstellung in Richtung zur Sicherheitsstellung bewegt, oder aber, sich diese Bewegung erst nach stärkerer Absenkung der Steuerspannung induzieren läßt. Ein solches Verhalten ist ersichtlich auf eine Verschlechterung der Güte des Piezobiegewandlers zurückzuführen.

Weiterhin kann in besonders zweckmäßiger Weise auch vorgesehen sein, dass die Steuereinheit dazu eingerichtet ist, die zur Betätigung des Piezobiegewandlers benötigte Steuerspannung in Abhängigkeit von Messwerten vorangegangener Funktionstests (und/oder in Abhängigkeit von dem Gütewert) dynamisch anzupassen.

Dies kann insbesondere auch zur Verminderung der Betriebsbelastung der typischerweise im Dauereinsatz betriebenen Piezobiegewandler genutzt werden, indem für Piezobiegewandler hoher Güte, bei denen bereits eine geringe Steuerspannung für eine maximale Auslenkung ausreicht, eine gezielte Absenkung der zum Halten der ausgelenkten Arbeitsstellung vorgesehenen Steuerspannung auf die jeweils aktuelle benötigte Mindestspannung erfolgt.

Ferner erweist es sich als besonders vorteilhaft, wenn der Piezobiegewandler durch Wahl einer geeigneten Geometrie und geeigneter Materialien so gestaltet ist, dass die elektrische Kapazität des Piezobiegewandlers über einen zulässigen Betriebstemperaturbereich von -40°C bis +80°C stets kleiner als 170 nF, bevorzugt kleiner als 100 nF ist. Von Vorteil ist außerdem, wenn die elektro-fluidische Vorstufe gemäß DIN EN 60079-11 zum Einsatz in explosionsgefährdeten Atmosphären, vorzugsweise als eigensicher ausgeführte Einheit, ausgestaltet ist.

Bei entsprechender Begrenzung der Maximalkapazität des Piezobiegewandlers auf einen unterhalb der explosionskritischen Grenzen liegenden Wert kann die elektro-fluidische Vorstufe ohne zusätzliche Maßnahmen über den gesamten industrietypischen Betriebstemperaturbereich als eigensicheres Produkt auch in explosionsgefährdeten Umgebungen eingesetzt werden. Durch konsequente Einhaltung der vorstehend genannten Explosions-Richtlinie (z.B. geeigneter Luft- und Kriechstrecken für die elektrischen Leiter etc.) und den Verzicht auf jegliche sonstige in die elektro-fluidische Vorstufe integrierte energiewandelnde Elektronik oder Sensorik, kann die Eigensicherheit des Pilotventils unabhängig vom Anwendungsfall ohne Zusatzaufwand gewährleistet werden. Die elektrische Anbindung der elektro-fluidischen Vorstufe an die (vorteilhaft als separates Modul mit eigenem Gehäuse ausgestaltete) elektronische Steuereinheit, die ebenfalls gemäß Explosionsschutzrichtlinie ausgelegt sein kann, erfolgt in besonders einfacher Weise mittels Zweileitertechnik, wobei die elektrische Verbindung bevorzugt mittels Steckkontakten mit hinreichend großen Leiterbahnabständen sichergestellt werden kann.

Der Piezobiegewandler kann zur Erfüllung der Explosionsschutzrichtlinien geometrisch und materialseitig insbesondere so gestaltet sein, dass er über einen Temperaturbereich von -40°C bis +80°C niemals mehr als 50pJ elektrische Energie speichert. Bei Vorgabe einer maximal zulässigen elektrischen Ansteuerspannung von 24 VDC kann dies, wie bereits vorstehend als besonders bevorzugte Ausgestaltung erwähnt, dadurch gewährleistet werden, dass die Biegewandlerkapazität C einen Höchstwert von 170 nF in jedem Betriebszustand einhält.

Weiterhin kann im Rahmen der vorliegenden Erfindung bevorzugt noch vorgesehen sein, dass die Steuereinheit eine Schnittstelle zur Kommunikation mit übergeordneten Steuerungs-, Regel-, Diagnose- und/oder Kommunikationseinrichtungen und -systemen (geeigneter Standards) aufweist und zur aktiven oder passiven Übermittlung von während der iterativen Funktionstests ermittelten Daten eingerichtet ist.

Die Steuereinheit des Sicherheitsventils und/oder das übergeordnete Steuerungs-, Regel oder Diagnosesystem kann insbesondere auch dazu eingerichtet sein, in Abhängigkeit von Messwerten der durchgeführten Funktionstests und bei Erreichen von insoweit vorgebbaren Warnschwellen, insbesondere bei einem sich sukzessive verschlechternden Gütewert, eine vollautomatische Aufforderung zur Durchführung von vorbeugenden Service- oder Reparaturmaßnahmen auszugeben.

Weitere im Rahmen der vorliegenden Erfindung, insbesondere in Zusammenhang mit den zu verwendenden Piezobiegewandlern, vorteilhaft berücksichtigbare Aspekte und Weiterbildungen ergeben sich noch aus den folgenden Anmerkungen:
Besonders leistungsfähig erweisen sich Piezobiegewandler, bei denen das piezoelektrisch aktive Material sowohl an der Oberseite als auch an der Unterseite der piezoelektrisch inaktiven Trägerschicht kraftschlüssig in jeweils mindestens einer Schichtlage angeordnet wird. Besonders vorteilhalt wird das piezoelektrische Material derart ausgewählt, dass sich die Gestaltänderung der mindestens einen Schicht auf der Oberseite bei gleichzeitiger elektrischer Anregung exakt gegenläufig zur Gestaltänderung auf der Unterseite verändert. Eine gleichzeitig initiierte Expansion der piezoelektrisch aktiven Schicht auf der einen sowie Kontraktion der inaktiven Trägerschicht auf der gegenüberliegenden Schicht verstärkt den Durchbiegeeffekt des Biegewandlers zusätzlich.

Für die flächig ausgeführte piezoelektrisch inaktive Trägerschicht erweist sich die Wahl eines dem piezoelektrisch aktiven Material artverwandten keramischen Materials mit vergleichbarem thermischen Verhalten als besonders vorteilhaft. Derartige Materialien konkurrieren mit faserverstärkt versteiften harzgetränkten Materialien, deren Steifigkeit abhängig von der gewählten Faserorientierung und geometrischen Ausgestaltung räumlich orientiert beeinflusst werden können, was ebenfalls vorteilhaft sein kann. Besonders vorteilhalt erweist sich auch eine Verwendung von Schichten aus elektrisch leitfähigen, faserverstärkten Materialen und/oder Harzsystemen, welche gleichzeitig die elektrische Kontaktierung mit der dem Faserverbund zugeordneten Schicht aus piezoelektrisch aktiven Materials ermöglichen. Über ihr integriertes Harzsystem schaffen sie einen zuverlässigen Toleranzausgleich bei geringfügigen geometrischen Dickenabweichungen der ihnen zugeordneten piezoelektrisch aktiven Materialen und gewähren einen sicheren Kraftschluss.

Piezobiegewandler neigen aufgrund ihres schichtartigen Aufbaus aus Materialien unterschiedlicher physikalischer Eigenschaften insbesondere zu bimetallartigem Verhalten hinsichtlich ihrer thermischen Eigenverbiegung. Sofern diese nicht durch geeignete Maßnahmen, wie z.B. die Sicherstellung einer geeigneten Werkstoffhomogenität und Dickenpaarung, prozesssicher eingeschränkt wird, kann das Ausmaß der thermischen Eigenverbiegung den Bereich der gewünschten piezoelektrisch induzierten Durchbiegung signifikant beeinträchtigen. Als vorteilhafte, dem Biegewandlerproduktionsprozess nachlagerbare Kompensationsmaßnahme, hat sich das gezielte Aufbringen geeigneter (dünnschichtiger) Kompensationsflächen oder -strukturen aus thermisch abweichendem Kompensationsmaterial bewährt. Durch das Aufbringen solch zusätzlicher Kompensationsflächen oder -strukturen auf der Biegewandlerober- bzw. -unterseite lässt sich ein thermisch induziertes Biegemoment einprägen, das der thermischen Eigenverbiegung entgegenwirkt und diese kompensiert. Die physikalischen Eigenschaften der Kompensationsfläche- oder struktur werden dabei vorteilhaft so gewählt, dass diese einerseits den beschriebenen thermischen Kompensationseffekt erfüllen, jedoch andererseits die leistungsbestimmenden Aktuatorkenngrößen (insbesondere der Leerlaufauslenkung und der Blockierkraft) nur minimal beeinflussen.

Zur optimalen Ausnutzung der in der Längsrichtung des in der Regel streifenförmigen Piezobiegewandlers aufgebrachten Aktuatorleistung wird dieser besonders vorteilhaft nahe einem ersten geometrischen Ende des Streifens auf seiner gesamten Breite mechanisch fest eingespannt. Seine zur Beeinflussung des sekundären Steuerfluidstroms benötigte Aktuatorbewegung und -kraft wird vorteilhaft nahe dem zweiten, gegenüberliegenden Ende abgegriffen. Da die Einspann- und Abgriffbereiche infolge der mechanischen Fixierung nicht zur Auslenkung beitragen, wird deren Längsausdehnung minimiert. Die mechanische Einspannung erfolgt daher vorzugsweise flächig oder linienförmig in Form einer biegesteifen Schneidenlagerung. Der Abgriff der Aktuatorbewergung und -kraft erfolgt vorteilhaft linienförmig oder auch punktförmig. Zur Vermeidung etwaiger Leistungsverluste durch Torsion erfolgt der Abgriff vorteilhaft entlang der Biegewandler-Mittellinie.

Soll ein erfindungsgemäßes Sicherheitsventil mit Piezobiegewandler in feuchter Umgebung zum Einsatz kommen, so sollten die elektrisch aktiven Elemente zur Kurzschluss- und Korrosionsvermeidung vor Feuchtigkeit geschützt werden. Vorteilhaft geschieht dies über flächige Auftragsschichten wie z.B. Feuchteschutzlacke oder mittels Kapselung durch feuchtigkeitsresistente Folienüberzüge. Zur Vermeidung etwaiger Kraftübertragungsverluste ist es vorteilhaft, den Feuchteschutz im Einspannbereich dergestalt selektiv auszusparen, dass eine direkte mechanische Einspannung ohne Zwischenschicht sichergestellt werden kann. Am Abgriff kann es demgegenüber von Vorteil sein, den Feuchteschutz mit zusätzlichen Funktionsstrukturen zu kombinieren. Auf diese Weise lassen sich selektive Kontaktflächen mit Abdichteigenschaften z.B. bei Ventilen oder Antihafteigenschaften z.B. an Kontakt- oder Dämpfungselementen mit minimaler Ablösekraft realisieren.

Piezoelektrisches Material neigt unter elektrischer oder mechanischer Dauerbelastung innerhalb gewisser Grenzen zur elektrischen oder mechanischen Relaxation. Wärme hat hierbei eine effektverstärkende Wirkung. Durch deren Zeitabhängigkeit vermindert sich der absolute Einfluss von Relaxationseffekte mit der Einwirkungsdauer der verursachenden Kenngröße. Das piezoelektrische aktive Material verliert durch Relaxation in gewissem Umfang die ihm während des Fertigungsprozesses eingeprägte Polarisation oder mechanische Eigenspannung. Vor diesem Hintergrund ist es besonders vorteilhaft, das elektrische Ansteuersignal (also die Steuerspannung) auf den für die Auslenkung notwendigen Spannungsbereich zu limitieren, wie dies bereits weiter oben ausgeführt wurde.

Während der Montage der mechanischen Einspannung sollten mechanische Störeinflüsse vorteilhaft entweder über eine optimale Orientierung zwischen Einspann- und Abgriffspunkten minimiert werden oder aber unter Verwendung einer geeigneten Justageeinrichtung ein spannungsarmer Fügeprozess mit anschließender Lagekorrektur vorgesehen werden.

Zur elektrischen Anregung der piezoelektrisch aktiven Schichten eines Piezobiegewandlers ist es erforderlich, diese einem vorteilhaft besonders homogenen elektrischen Feld auszusetzen. Zur Herstellung der Elektrodenflächen kann das piezoelektrische Folienmaterial im Fertigungsprozess hierfür beidseitig dünnflächig metallisiert werden. Nach Heraustrennen einzelner Folienelemente mittels geeigneter Besäumungsverfahren, wie z.B. Sägen, Ritzen und Brechen, lässt sich das piezoelektrische Folienmaterial elektrisch mit einem beidseitig vorzusehenden Punktkontakt ganzflächig anregen. Für symmetrisch aufgebaute Biegewandler mit je einer piezoelektrisch aktiven Schicht auf der Ober- und Unterseite sowie einer elektrisch leitfähigen Trägerschicht lässt sich das Bauelement besonders einfach kontaktieren. Hierbei reicht es aus, die Trägerschicht sowie die Außenelektrodenflächen über je einen elektrischen Punktkontakt anzubinden.

Zur elektrischen Anregung piezoelektrisch aktiver Schichten bedarf es an deren beidseitigen Elektrodenflächen der Anlegung einer elektrischen Steuerspannung. Diese prägt dem dazwischenliegenden piezoelektrisch aktiven Material ein homogenes elektrisches Feld auf. Die Isolationseigenschaften des piezoelektrisch aktiven Materials verhindern jegliche Stromleitung, wodurch ausschließlich für den Auf- oder Umladevorgang der Elektrodenflächen Strom fließt.

Die elektrische Kapazität des Piezobiegewandlers ergibt sich im Wesentlichen aus der Anzahl der beteiligten piezoelektrisch aktiven Elemente, deren Elektrodenflächen sowie der Permittivität des piezoelektrisch aktiven Materials. Zur Minimierung der elektrischen Relaxation ist es bei piezoelektrischen Biegewandlern vorteilhaft, Umladevorgänge über einen kurzzyklischen elektrischen Anregeimpuls mit gleichgerichtetem Vorzeichen der Änderungsrichtung zu initiieren und die Haltespannung sowie das dadurch initiierte elektrische Feld über das piezoelektrische Material nach Erreichen der neuen Sollposition in zulässigem Maß abzusenken, ohne dadurch eine erneute Positionsänderung zu initiieren.

Zur optimalen Ausnutzung anwendungsunabhängiger Skaleneffekte ist es im Rahmen der Auslegung und Herstellung erfindungsgemäßer Sicherheitsventile aufgrund wirtschaftlicher Überlegungen besonders sinnvoll, das aus elektronischer Steuereinheit und elektro-fluidischer Vorstufe bestehende elektro-fluidische Interface hinsichtlich seiner physikalischen Produkteigenschaften in den wesentlichen Merkmalen zu standardisieren. Als elektrisch betätigter Aktuator für besonders energieeffiziente Anwendungen ergeben sich daraus für einen breiten Einsatz die nachfolgenden, und im Rahmen der Umsetzung der vorliegenden Erfindung als besonders vorteilhaft anzusehenden Produkteigenschaften:
- Begrenzung der maximal zulässigen elektrischen Steuerspannung auf industrietypische 24 VDC
- Limitierung der im Piezobiegewandler speicherbaren elektrischen Energie auf maximal 50pJ für eigensichere Aktuatoren. Bei einer Maximalspannung von 24 VDC leitet sich hieraus eine vorteilhafte elektrische Maximalkapazität der Piezoaktuators von 170 nF ab.
- Vorgabe des Arbeitsdrucks für das sekundäre Steuerfluid von 1,2 bar in Anlehnung an das gängige pneumatische Einheitssignal
- Auslegung des Interfaces für den Standard-Einsatztemperaturbereich der Prozessindustrie von -40°C bis 80 °C

Neben den bereits weiter oben ausführlich beschriebenen Komponenten kann ein erfindungsgemäßes Sicherheitsventil, welches insbesondere modulartig aufgebaut sein kann, schließlich noch ein Druckmedien-Aufbereitungsmodul aufweisen, welches die anwendungsgerechte Aufbereitung des sekundären Steuermedienstroms übernimmt. Neben einem Filterelement kann es dabei einen Vordruckregler zur Überlastsicherung des bereitgestellten Versorgungsdrucks im sekundären Steuerfluidstrom enthalten.

Nachfolgend wird ein Ausführungsbeispiel eines erfindungsgemäßen Sicherheitsventils bzw. der darin verwendbaren Komponenten anhand der Zeichnung näher erläutert.

Dabei zeigt
- Fig. 1: eine schematische Darstellung, teils im Querschnitt, von sämtlichen Komponenten eines Ausführungsbeispiels eines erfindungsgemäßen Sicherheitsventils,
- Fig. 2: typische Signal- und Druckverläufe während eines erfindungsgemäß realisierten Funktionstests, und
- Fig. 3: eine Darstellung zum Verlauf einer Phasenverschiebung zwischen Eingangs- und Antwortsignal als Funktion der Position des Piezobiegewandlers.

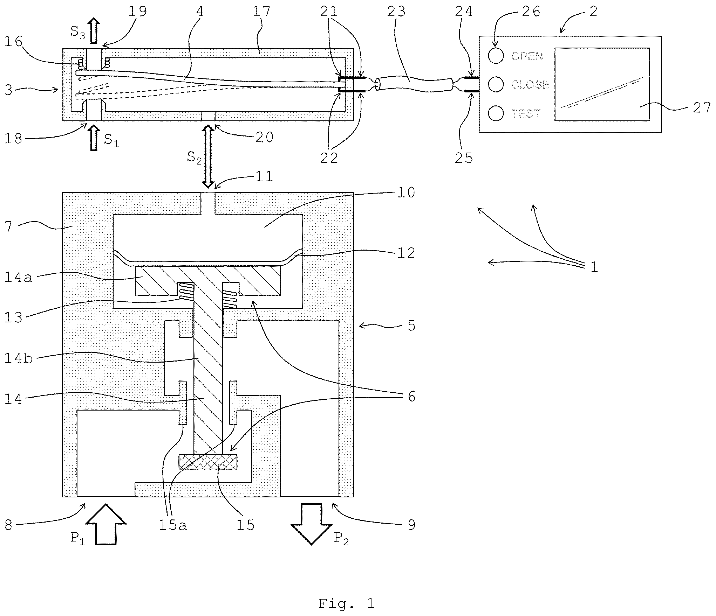

Fig. 1 zeigt ein Ausführungsbeispiel eines erfindungsgemäßen und modulartig ausgestalteten Sicherheitsventils 1. Dieses umfasst eine elektronische Steuereinheit 2 zur Erzeugung einer Steuerspannung, eine elektro-fluidischen Vorstufe 3 mit einem mittels der Steuerspannung zwischen einer Arbeits- und einer Sicherheitsstellung betätigbaren Piezobiegewandler 4, welcher stellungsabhängig den durch die Pfeile S₁, S₂, S₃ angedeuteten Fluss eines sekundären Steuerfluidstroms beeinflusst, und eine fluid-mechanische Hauptstufe 5 mit einer Beeinflussungseinrichtung 6 zur Beeinflussung des durch die Pfeile P₁, P₂ angedeuteten Flusses eines primären Arbeitsfluidstroms.

Die Hauptstufe 5 ist hier als NG-Variante (NG = Normal Geschlossen) in betätigtem Zustand ausgeführt. Sie umfasst ein Gehäuse 7, einen fluidischem Eingang 8 und einen fluidischem Ausgang 9 für den primären Arbeitsfluidstrom, einen Steuerraum 10 mit Anschluss 11 für den Sekundärfluidstrom S₂, der durch eine Membran 12 abgetrennt wird, ein mittels einer Feder 13 rückgestelltes (und vorliegend gegen die Federkraft ausgelenktes) Betätigungselement 14 sowie ein daran befestigtes Dichtelement 15, welches bei nach oben verschobenem Betätigungselement 14 mit einem Dichtsitz 15a den primären Arbeitsfluidstrom durch die Hauptstufe 5 sperrt. Das längsverschiebbare Betätigungselement 14 besteht aus einem mit der Membran 12 verbundenen Membranteller 14a sowie einem daran befestigten Schaft 14b, der in den Primärfluss hineinragt und an dessen freien Ende das Dichtelement 15 befestigt ist. Die Übersetzung zwischen Vorstufe 3 und Hauptstufe 5 wird im Wesentlichen durch das Flächenverhältnis von Membranteller 14a zu Dichtelement 15 bestimmt.

Die Vorstufe 3 ist als Piezoventil ausgeführt, wobei der Piezobiegewandler 4 sowohl in seinem betätigten Arbeitszustand (mit durchgängiger Linie) als auch in seiner Sicherheitsstellung (mit gestrichelter Linie) dargestellt ist. Die Einnahme der Sicherheitsstellung (bei nicht vorhandener Steuerspannung) wird dabei durch eine den Piezobiegewandler in Richtung zur Sicherheitsstellung vorspannende Feder 16 erzwungen. Beide Elemente (d.h. der Piezobiegewandler 4 und die Feder 16) befinden sich in einem Gehäuse 17 der Vorstufe 3, welches einen Versorgungsanschluss 18 (für das unter Druck stehende sekundäre Steuerfluid), einen Entlüftungsanschluss 19 sowie einen Anschluss 20 für den zum/vom Steuerraum 10 der Hauptstufe 5 führenden Sekundärfluidstrom aufweist, welcher auf geeignete Weise mit dem oberen Anschluss 11 am Gehäuse 7 der Hauptstufe 5 zu verbinden ist.

In der Arbeitsstellung des Piezobiegewandlers 4 besteht ein Fluidpfad zwischen Versorgungseingang 18 und dem zur Hauptstufe 5 führenden Ausgang 20 der Vorstufe 3, während der Entlüftungsanschluss 19 durch das freie Ende des Piezobiegewandlers 4 verdeckt bzw. gesperrt ist.

In der gestrichelt dargestellten Sicherheitsstellung des Piezobiegewandlers 4 ist demgegenüber der Versorgungseingang 18 durch das freie Ende des Piezobiegewandlers 4 verdeckt, so dass in dieser Stellung ein Fluidpfad zwischen dem Anschluss 20 und dem Entlüftungsanschluss 19 besteht, was zur Entlüftung des Steuerraum 10 der Hauptstufe führt, so dass dann die Beeinflussungseinrichtung 6 der Hauptstufe 5 aufgrund ihrer Federvorspannung in die den primären Arbeitsfluidstrom sperrende Endlage überführt wird.

Die zur Versorgung des Piezobiegewandlers 4 mit der Steuerspannung benötigten elektrischen Leiter 21, 22 der Vorstufe sind durch das Gehäuse 7 nach außen geführt, von wo aus sie in üblicher Weise - z.B. unter Zuhilfenahme geeigneter Stecker - mittels eines Kabels 23 an hierzu korrespondierenden Anschlüssen 24, 25 der Steuereinheit 2 angeschlossen werden, wobei hierfür im gegebenen Ausführungsbeispiel die einfachste Variante einer Zweileiterverbindung gewählt ist.

Die in üblicher Weise zur Steuerung des Sicherventils 1 und insbesondere zur Erzeugung einer Steuerspannung geeignet eingerichtete Steuereinheit 2 ist nur schematisch dargestellt. Sie umfasst neben der (nicht dargestellten) Steuerelektronik, welche in erfindungsgemäßer Weise zur Durchführung von iterativ zu wiederholenden Funktionstests der Vorstufe 3 eingerichtet ist, auch Bedienelemente 26, ein Anzeigeelement 27 und geeignete Anschlüsse bzw. Schnittstellen (nicht dargestellt) zur Kommunikation mit übergeordneten Steuerungs-, Regel-, Diagnose- und/oder Kommunikationseinrichtungen und -systemen und zur aktiven oder passiven Übermittlung von während der iterativen Funktionstests ermittelten Daten. Ferner können geeignete Signaleingänge für etwaige zur Steuerung des Ventils benötigte Messignale vorgesehen sein.

Die auf geeignete Weise für den sekundären Steuerfluidstrom herzustellende Verbindung zwischen den Anschlüssen 20, 11 an Vor- und Hauptstufe 3, 5 ist durch einen Doppelpfeil dargestellt. Die Beeinflussungseinrichtung 6 der Hauptstufe 5 ist somit mittels des in den Steuerraum 10 der Hauptstufe 5 mündenden sekundären Steuerfluidstroms betätigbar, wobei bei der in Fig. 1 gezeigten Arbeitsstellung des Piezobiegewandlers 4 der am Versorgungsanschluss 18 der Vorstufe 3 anliegende Druck dem Steuerraum 10 der Hauptstufe 5 zugeführt wird, wodurch die Beeinflussungseinrichtung 6 der Hauptstufe 5, wie dargestellt, den den primären Arbeitsfluidstrom freigebenden Schaltzustand einnimmt.

Wird nun durch Ausschalten oder Absenkung der Steuerspannung mittels der Steuereinheit 2 der Piezobiegewandler 4 in die in Fig. 1 gestrichelt dargestellte Sicherheitsstellung überführt bzw. in diese Richtung ausgelenkt, so verringert sich (aufgrund des Öffnens des Entlüftungsanschlusses 19) der Druck im Steuerraum 10, da das darin unter Druck stehende sekundäre Steuerfluid zurück zur Vorstufe 3 fließen und gemäß Pfeil S₃ durch den Entlüftungsausgang 19 entweichen kann.

Die Steuereinheit 2 des erfindungsgemäßen Sicherheitsventils 1 ist zur vollautomatischen und nach Ablauf vorgegebener Zeitintervalle (von z.B. zwischen 8 und 72 Stunden) iterativ zu wiederholenden Durchführung eines Funktionstests der elektro-fluidischen Vorstufe 3 eingerichtet, wobei im Rahmen des Funktionstests unter geeigneter Variation der Steuerspannung eine derart kurzzeitige und/oder derart geringfügige Veränderung der Stellung des Piezobiegewandlers 4 herbeigeführt wird, dass zwar einerseits unter gleichzeitig erfolgender Ermittlung einer tatsächlich erfolgenden Auslenkungsbewegung des Piezobiegewandlers 4 dessen korrekte Funktionsweise überprüfbar ist, jedoch andererseits keinerlei Beeinflussung des Flusses des primären Arbeitsfluidstroms durch die Hauptstufe 5 erfolgt.

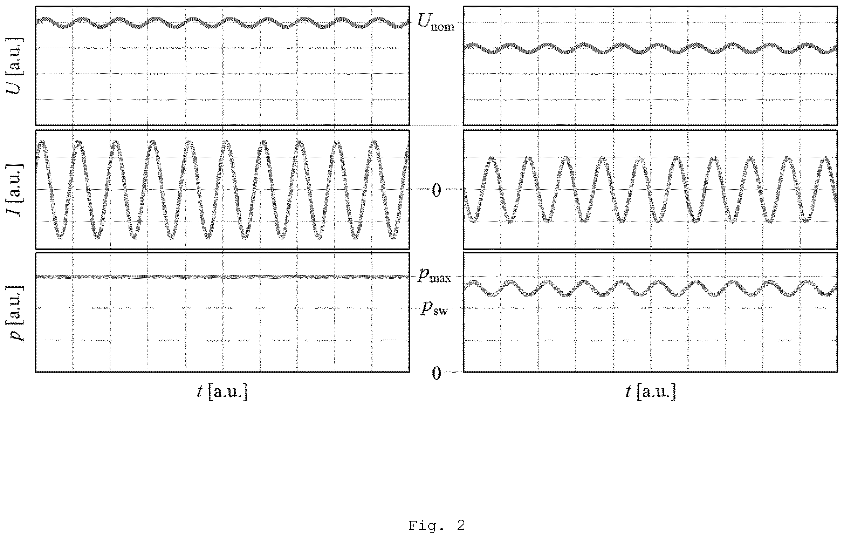

Fig. 2 zeigt beispielhaft die Signal- und Druckverläufe während eines erfindungsgemäß realisierten Funktionstests, bei welchem der Steuerspannung ein Messignal aufmoduliert und als Antwortsignal der hierdurch induzierte (Wechsel-)Strom gemessen wird.

Dabei zeigen die Graphen der linken Spalte die Signalverläufe bei nomineller Steuerspannung (Uₙₒₘ), also in Arbeitsstellung.

Die Graphen in der rechten Spalte zeigen die jeweiligen Signalverläufe bei reduzierter Steuerspannung, wobei der Piezobiegewandler 4 bereits seine Endlage verlassen hat.

Die Graphen in der oberen Reihe zeigen jeweils die Steuerspannung U, der eine Wechselspannung niedriger Amplitude als Messignal aufmoduliert ist. Die mittlere Reihe zeigt das jeweils als Antwortsignal gemessene Stromsignal I und die untere Reihe zeigt den sich am (zum Steuerraum 10 der Hauptstufe 5 führenden) Ausgang 20 der Vorstufe 3 ergebenden Druck p.

Das aufmodulierte Spannungssignal hat in dem skizzierten Fall eine Frequenz, die nahe und leicht oberhalb der Resonanzfrequenz des Piezobiegewandlers 4 in seiner Endlage liegt.

In Arbeitsstellung ist der Druck am Ausgang 20 der Vorstufe 3 konstant. Zwischen Spannung und Strom stellt sich eine geringe positive Phasenverschiebung ein.

Wird nun die Ansteuerspannung abgesenkt, verlässt der Piezobiegewandler 4 seine Endlage und der Druck sinkt leicht ab, wobei im Rahmen des erfindungsgemäß realisierten Funktionstests durch geeignete Vorgabe des Volumens des Steuerraums 10, der gegebenen Druckverhältnisse und/oder der zur Betätigung der Beeinflussungseinrichtung 6 der Hauptstufe 5 benötigten Energie (welche z.B. auch durch die Rückstellkraft der Feder 13 der Hauptstufe 5 bestimmt wird) dafür Sorge getragen ist, dass der Druck zu jedem Zeitpunkt oberhalb des für die Betätigung der Beeinflussungseinrichtung 6 der Hauptstufe 5 notwendigen Schaltdrucks (p_{sw}) ist. Hierdurch kann somit ein Funktionstest der Vorstufe realisiert werden, ohne dabei Einfluss auf den primären Arbeitsfluidstrom zu nehmen.

Durch das Verlassen der Endlage ergibt sich im Antwortsignal eine Änderung der Phasenlage und der Amplitude, so dass im Falle des Vorhandenseins einer Phasenverschiebung zwischen dem der Versorgungsspannung aufmodulierten Messsignal und dem (als Stromfluss gemessenen) Antwortsignal, die von der in der Arbeitsstellung gegebenen Phasenverschiebung abweicht, auf eine tatsächliche Auslenkung des Piezobiegewandlers aus seiner Endlage und somit auf dessen korrekte Funktionsweise geschlossen werden kann. Die Phasenverschiebung zwischen Strom und Spannung beträgt nun im gegebenen Beispiel - 180° (vgl. die in den oberen zwei Graphen dargestellten Signalverläufe in der rechten Spalte von Fig. 2).

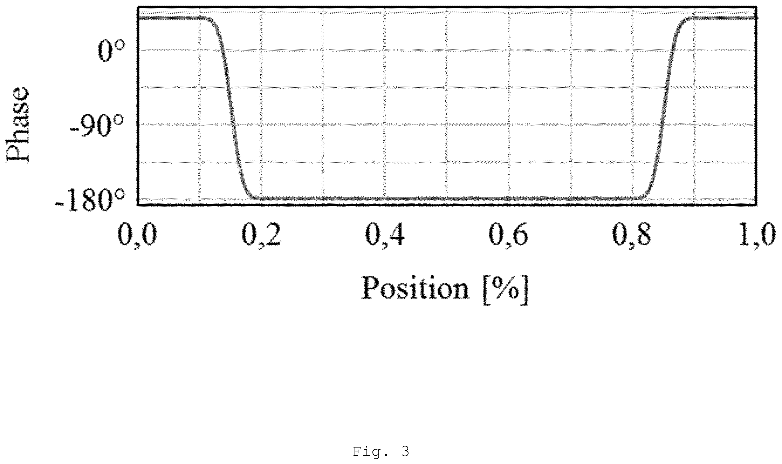

Fig. 3 zeigt schließlich für das gegebene Ausführungsbeispiel den Verlauf der Phasenverschiebung als Funktion der (relativen) Position/Auslenkung des Piezobiegewandlers 4 aus seiner Arbeitsstellung, wobei ein Wert von 1 der Überführung des Piezobiegwandlers in seine Sicherheitsstellung entspricht.

Der in Fig. 3 dargestellte Graph ist zusammen mit den Erläuterungen zu Fig. 2 weitestgehend selbsterklärend. Der genaue Verlauf der Phasenverschiebung hängt dabei von der Frequenz des aufmodulierten Signals ab. Es ist wiederum ein Fall skizziert, der für eine Frequenz nahe und leicht oberhalb der Resonanzfrequenz des Piezobiegewandlers in der Endlage gilt.

## Patentansprüche

1. Sicherheitsventil (1) mit
- einer elektronischen Steuereinheit (2) zur Erzeugung einer Steuerspannung,
- einer elektro-fluidischen Vorstufe (3), welche einen mittels der Steuerspannung zwischen einer Arbeits- und einer Sicherheitsstellung betätigbaren Piezobiegewandler (4) aufweist, welcher stellungsabhängig den Fluss eines sekundären Steuerfluidstroms beeinflusst, und
- einer fluid-mechanischen Hauptstufe (5) mit einer Beeinflussungseinrichtung (6) zur Beeinflussung des Flusses eines primären Arbeitsfluidstroms, wobei die Beeinflussungseinrichtung (6) mittels des in einen Steuerraum (10) der Hauptstufe (5) mündenden sekundären Steuerfluidstroms betätigbar ist,
**dadurch gekennzeichnet,**
**dass** die Steuereinheit (2) zur vollautomatischen und nach Ablauf vorgegebener Zeitintervalle iterativ zu wiederholenden Durchführung eines Funktionstests der elektro-fluidischen Vorstufe (3) eingerichtet ist, und dass im Rahmen des Funktionstests unter geeigneter Variation der Steuerspannung eine derart kurzzeitige und/oder derart geringfügige Veränderung der Stellung des Piezobiegewandlers (4) herbeigeführt wird, dass zwar einerseits unter gleichzeitig erfolgender Ermittlung einer tatsächlich erfolgenden Auslenkungsbewegung des Piezobiegewandlers (4) dessen korrekte Funktionsweise überprüfbar ist, jedoch andererseits keinerlei Beeinflussung des Flusses des primären Arbeitsfluidstroms durch die Hauptstufe (5) erfolgt.

2. Sicherheitsventil (1) nach Anspruch 1,
**dadurch gekennzeichnet,**
**dass** die Beeinflussungseinrichtung (6) der fluid-mechanischen Hauptstufe (5) durch geeignete Vorgabe des Volumens des Steuerraums (10), der gegebenen Druckverhältnisse und/oder der zu ihrer Betätigung benötigten Energie nur mit einer so großen Zeitverzögerung durch das in den Steuerraum einströmende sekundäre Steuerfluid betätigt wird, dass der Piezobiegewandler (4) im Rahmen des Funktionstests durch kurzzeitige Abschaltung der Steuerspannung aus seiner Arbeitsstellung in seine Sicherheitsstellung und wieder zurück bewegt werden kann, ohne dass sich dabei eine Beeinflussung des Flusses des primären Arbeitsfluidstroms durch die Hauptstufe (5) ergibt.

3. Sicherheitsventil (1) nach Anspruch 1,
**dadurch gekennzeichnet,**
**dass** der Piezobiegewandler (4) während des Funktionstests durch geeignete Absenkung der Steuerspannung nur geringfügig aus seiner Arbeitsstellung ausgelenkt wird.

4. Sicherheitsventil nach einem der vorangehenden Ansprüche,
**dadurch gekennzeichnet,**
**dass** die elektronische Steuereinheit (2), die elektro-fluidische Vorstufe (3) und/oder die fluid-mechanische Hauptstufe (5) jeweils als separate Module ausgeführt sind.

5. Sicherheitsventil nach einem der vorangehenden Ansprüche,
**dadurch gekennzeichnet,**
**dass** die elektro-fluidische Vorstufe (3) mit Ausnahme der zur Versorgung des Piezobiegewandlers (4) mit der Steuerspannung notwendigen elektrischen Leiter (21, 22) keine sonstigen elektrischen und/oder elektronischen Komponenten enthält.

6. Sicherheitsventil (1) nach einem der vorangehenden Ansprüche, insbesondere nach Anspruch 5,
**dadurch gekennzeichnet,**
**dass** die Steuereinheit (2) dazu eingerichtet ist, dem Piezobiegewandler (4) während des Funktionstests zu Diagnosezwecken über die auch die Steuerspannung führenden Leiter (21, 22) ein auswertbares elektrisches Messsignal aufzumodulieren.

7. Sicherheitsventil (1) nach Anspruch 6,
**dadurch gekennzeichnet,**
**dass** die Steuereinheit (2) zur Erfassung und Auswertung eines durch das Messsignal verursachten Antwortsignals eingerichtet ist, um so eine tatsächlich erfolgte Auslenkungsbewegung des Piezobiegewandlers (4) zu ermitteln.

8. Sicherheitsventil (1) nach Anspruch 6 und Anspruch 7, **dadurch gekennzeichnet,**
**dass** das Messignal eine Wechselspannung ist und dass unter Auswertung der Phasenverschiebung zwischen Messignal und des hierdurch als Antwortsignal induzierten Wechselstroms eine Impedanzänderung des Piezobiegewandlers (4) ermittelt wird, die zu einer tatsächlichen Auslenkungsbewegung des Piezobiegewandlers (4) korrespondiert.

9. Sicherheitsventil (1) nach einem der Ansprüche 1 - 5, **dadurch gekennzeichnet,**
**dass** die Steuereinheit (2) dazu eingerichtet ist, eine tatsächlich erfolgte Auslenkungsbewegung des Piezobiegewandlers (4) durch Messung der Kapazität und/oder einer Veränderung des Resonanzverhaltens des Piezobiegewandlers (4) zu ermitteln.

10. Sicherheitsventil (1) nach einem der vorangehenden Ansprüche,
**dadurch gekennzeichnet,**
**dass** die Steuereinheit (2) dazu eingerichtet ist, die Länge des Zeitintervalls zwischen zwei Funktionstests in Abhängigkeit von einem die Güte des Piezobiegewandlers (4) repräsentierenden Gütewert zu bestimmen, welcher seinerseits in einer vorzugsweise der Steuereinheit (2) zugeordneten Speichereinheit hinterlegt ist.

11. Sicherheitsventil (1) nach Anspruch 10,
**dadurch gekennzeichnet,**
**dass** die Steuereinheit (2) dazu eingerichtet ist, den Gütewert und die sich hieraus ergebende Länge des Zeitintervalls zwischen zwei Funktionstests in Abhängigkeit von Messwerten vorangegangener Funktionstests dynamisch anzupassen.

12. Sicherheitsventil (1) nach einem der vorangehenden Ansprüche,
**dadurch gekennzeichnet,**
**dass** die Steuereinheit (2) dazu eingerichtet ist, die zur Betätigung des Piezobiegewandlers (4) benötigte Steuerspannung in Abhängigkeit von Messwerten vorangegangener Funktionstests dynamisch anzupassen.

13. Sicherheitsventil (1) nach einem der vorangehenden Ansprüche,
**dadurch gekennzeichnet,**
**dass** der Piezobiegewandler (4) durch Wahl einer geeigneten Geometrie und geeigneter Materialien so gestaltet ist, dass die elektrische Kapazität des Piezobiegewandlers (4) über einen zulässigen Betriebstemperaturbereich von -40°C bis +80°C stets kleiner als 170 nF, bevorzugt kleiner als 100 nF ist.

14. Sicherheitsventil (1) nach wenigstens einem der vorangehenden Ansprüche, insbesondere nach Anspruch 5 und Anspruch 13,
**dadurch gekennzeichnet,**
**dass** die elektro-fluidische Vorstufe (2) gemäß DIN EN 60079-11 zum Einsatz in explosionsgefährdeten Atmosphären, vorzugswiese als eigensicher ausgeführte Einheit, ausgestaltet ist.

15. Sicherheitsventil (1) nach wenigstens einem der vorangehenden Ansprüche,
**dadurch gekennzeichnet,**
**dass** die Steuereinheit (2) eine Schnittstelle zur Kommunikation mit übergeordneten Steuerungs-, Regel-, Diagnose- und/oder Kommunikationseinrichtungen und - systeme aufweist und zur aktiven oder passiven Übermittlung von während der iterativen Funktionstests ermittelten Daten eingerichtet ist.

## Claims

1. Safety valve (1) with
- an electronic control unit (2) for generation of a control voltage,
- an electrofluidic pilot stage (3), which comprises a piezo bending transducer (4) that can be actuated by means of the control voltage between a working and a safety position and that influences the flow of a secondary control fluid flow in position-dependent manner, and
- a fluid-mechanical main stage (5) having an influencing device (6) for influencing the flow of a primary working fluid flow, wherein the influencing device (6) can be actuated by means of the secondary control fluid flow discharging into a control chamber (10) of the main stage (5),
**characterized in that** the control unit (2) is configured for performance, to be repeated iteratively in fully automatic manner and after expiration of specified time intervals, of a function test of the electrofluidic pilot stage (3), and **in that** a change in the position of the piezo bending transducer (4) is induced during the function test by suitable variation of the control voltage, which change is so transient and/or so small that, on the one hand, correct functioning of the piezo bending transducer (4) can indeed be checked by simultaneously occurring determination of an actually occurring deflection movement thereof, but on the other hand the flow of the primary working fluid flow through the main stage (5) is not influenced in any way.

2. Safety valve (1) according to claim 1,
**characterized in that**, by suitable specification of the volume of the control chamber (10), of the existing pressure ratios and/or of the energy needed for its actuation, the influencing device (6) of the fluid-mechanical main stage (5) is actuated by the secondary control fluid flowing into the control chamber only with a time delay of such magnitude that the piezo bending transducer (4) can be moved during the function test, by transient disconnection of the control voltage, from its working position to its safety position and back again, without resulting in an influence on the flow of the primary working fluid flow through the main stage (5).

3. Safety valve (1) according claim 1,
**characterized in that** the piezo bending transducer (4) is deflected only slightly from its working position during the function test by suitably reducing the control voltage.

4. Safety valve according to any one of the preceding claims, **characterized in that** the electronic control unit (2), the electrofluidic pilot stage (3) and/or the fluid-mechanical main stage (5) are respectively constructed as separate modules.

5. Safety valve according to any one of the preceding claims, **characterized in that** the electrofluidic pilot stage (3) contains no electrical and/or electronic components other than the electrical conductors (21, 22) necessary to supply the piezo bending transducer (4) with the control voltage.

6. Safety valve (1) according to any one of the preceding claims, in particular according to claim 5,
**characterized in that** the control unit (2) is configured to modulate an evaluable electrical measurement signal onto the piezo bending transducer (4) during the function test for diagnostic purposes via the conductors (21, 22) that also carry the control voltage.

7. Safety valve (1) according to claim 6,
**characterized in that** the control unit (2) is configured for acquisition and evaluation of a response signal induced by the measurement signal, in order that a deflection movement of the piezo bending transducer (4) that has actually occurred can be determined.

8. Safety valve (1) according to claims 6 and 7,
**characterized in that** the measurement signal is an a.c. voltage and **in that**, by evaluation of the phase shift between the measurement signal and the alternating current induced thereby as a response signal, a change of impedance of the piezo bending transducer (4) can be determined that corresponds to an actual deflection movement of the piezo bending transducer (4).

9. Safety valve (1) according to any one of claims 1 - 5, **characterized in that** the control unit (2) is configured to determine, by measurement of the capacitance and/or of a change of the resonance behavior of the piezo bending transducer (4), a deflection movement of the piezo bending transducer (4) that has actually occurred.

10. Safety valve (1) according to any one of the preceding claims, **characterized in that** the control unit (2) is configured to determine the length of the time interval between two function tests in dependence on a rating representing the quality of the piezo bending transducer (4), which rating in turn is resident in a memory unit preferably assigned to the control unit (2).

11. Safety valve (1) according to claim 10,
**characterized in that** the control unit (2) is configured to dynamically adapt the rating and the resulting length of the time interval between two function tests in dependence on measured values of previous function tests.

12. Safety valve (1) according to any one of the preceding claims, **characterized in that** the control unit (2) is configured to dynamically adapt the control voltage needed for actuation of the piezo bending transducer (4) in dependence on measured values of previous function tests.

13. Safety valve (1) according to any one of the preceding claims, **characterized in that** the piezo bending transducer (4) is configured by choice of a suitable geometry and suitable materials in such a way that the electrical capacitance of the piezo bending transducer (4) over a permissible operating temperature range of -40° C to +80° C is always smaller than 170 nF, preferably smaller than 100 nF.

14. Safety valve (1) according to at least one of the preceding claims, in particular according to claim 5 and claim 13, **characterized in that** the electrofluidic pilot stage (2) according to DIN EN 60079-11 is equipped for use in potentially explosive atmospheres, preferably as a unit constructed to be intrinsically safe.

15. Safety valve (1) according to at least one of the preceding claims,
**characterized in that** the control unit (2) comprises an interface for communication with higher-level control, regulation, diagnostic and/or communications devices and systems and is configured for active or passive transmission of data determined during the iterative function tests.

## Revendications

1. Soupape de sécurité (1) avec
- une unité de commande électronique (2) pour produire une tension de commande,
- un niveau préliminaire électro-fluidique (3), lequel comporte un transducteur de flexion piézoélectrique (4) actionnable au moyen de la tension de commande entre une position de travail et une position de sécurité, lequel influence en fonction de la position l'écoulement d'un débit de fluide de commande secondaire, et
- un niveau principal fluido-mécanique (5) avec un système d'influence (6) pour influencer l'écoulement d'un débit de fluide de travail primaire, sachant que le système d'influence (6) peut être actionné au moyen du débit de fluide de commande secondaire débouchant dans un compartiment de commande (10) du niveau principal (5),
**caractérisée en ce que**
l'unité de commande (2) est agencée pour l'exécution entièrement automatique, et, après expiration de l'intervalle de temps prédéfini, itérativement à répéter d'un essai de fonctionnement du niveau préliminaire électro-fluidique (3) et **en ce que** dans le cadre de l'essai de fonctionnement, une modification si brève et/ou si minime de la position du transducteur de flexion piézoélectrique (4) est causée par une variation appropriée de la tension de commande que d'une part avec détermination ayant lieu simultanément d'un mouvement de déviation ayant effectivement lieu du transducteur de flexion piézoélectrique (4), dont le mode de fonctionnement correct peut être vérifié, d'autre part aucune influence de l'écoulement du débit de fluide de travail primaire n'a cependant lieu à travers le niveau principal (5).

2. Soupape de sécurité (1) selon la revendication 1, **caractérisée en ce que**
le système d'influence (6) du niveau principal fluido-mécanique (5) est actionné par définition préalable appropriée du volume du compartiment de commande (10), des rapports de pression donnés et/ou de l'énergie nécessaire à son actionnement uniquement avec une temporisation par le fluide de commande secondaire affluant dans le compartiment de commande de telle importance que le transducteur de flexion piézoélectrique (4) peut être à nouveau déplacé de sa position de travail dans sa position de sécurité et à nouveau en arrière dans le cadre de l'essai de fonctionnement par arrêt bref de la tension de commande sans qu'il en résulte à cet effet une influence sur l'écoulement du débit de fluide de travail primaire à travers le niveau principal (5).

3. Soupape de sécurité (1) selon la revendication 1, **caractérisée en ce que**
le transducteur de flexion piézoélectrique (4) n'est que faiblement dévié de sa position de travail pendant l'essai de fonctionnement par une baisse appropriée de la tension de commande.

4. Soupape de sécurité selon l'une quelconque des revendications précédentes,
**caractérisée en ce que**
l'unité de commande électronique (2), le niveau préliminaire électro-fluidique (3) et/ou le niveau principal fluido-mécanique (5) sont respectivement réalisés sous la forme de modules séparés.

5. Soupape de sécurité selon l'une quelconque des revendications précédentes, **caractérisée en ce que** le niveau préliminaire électro-fluidique (3) ne contient pas de composants électriques et/ou électroniques divers à l'exception des conducteurs électriques (21, 22) nécessaires à l'alimentation du transducteur de flexion piézoélectrique (4) avec la tension de commande.

6. Soupape de sécurité (1) selon l'une quelconque des revendications précédentes, en particulier selon la revendication 5,
**caractérisée en ce que**
l'unité de commande (2) est agencée pour moduler un signal de mesure exploitable au transducteur de flexion piézoélectrique (4) pendant l'essai de fonctionnement à des fins de diagnostic par le biais des conducteurs (21, 22) transportant également la tension de commande.

7. Soupape de sécurité (1) selon la revendication 6, **caractérisée en ce que**
l'unité de commande (2) est agencée pour la saisie et l'évaluation d'un signal de réponse causé par le signal de mesure pour déterminer ainsi un mouvement de déviation du transducteur de flexion piézoélectrique (4) ayant eu lieu effectivement.

8. Soupape de sécurité (1) selon la revendication 6 et la revendication 7,
**caractérisée en ce que**
le signal de mesure est une tension alternative et **en ce qu'**en évaluant le déphasage entre le signal de mesure et le courant alternatif induit de ce fait comme signal de réponse, une modification d'impédance du transducteur de flexion piézoélectrique (4) est déterminée, qui correspond à un mouvement de déviation effectif du transducteur de flexion piézoélectrique(4).

9. Soupape de sécurité (1) selon l'une quelconque des revendications 1 - 5,
**caractérisée en ce que**
l'unité de commande (2) est agencée pour déterminer un mouvement de déviation ayant effectivement eu lieu du transducteur de flexion piézoélectrique (4) en mesurant la capacité et/ou une modification du comportement de résonance du transducteur de flexion piézoélectrique (4) .

10. Soupape de sécurité (1) selon l'une quelconque des revendications précédentes,
**caractérisée en ce que**
l'unité de commande (2) est agencée pour déterminer la longueur de l'intervalle de temps entre deux essais de fonctionnement en fonction d'une valeur de qualité représentant la qualité du transducteur de flexion piézoélectrique (4), laquelle est mémorisée dans une unité de mémorisation attribuée de son côté de préférence à l'unité de commande (2).

11. Soupape de sécurité (1) selon la revendication 10, **caractérisée en ce que**
l'unité de commande (2) est agencée pour adapter dynamiquement la valeur de qualité et la longueur de l'intervalle en résultant entre deux essais de fonctionnement en fonction des valeurs de mesure des essais de fonctionnement précédents.

12. Soupape de sécurité (1) selon l'une quelconque des revendications précédentes,
**caractérisée en ce que**
l'unité de commande (2) est agencée pour adapter dynamiquement la tension de commande nécessaire à l'actionnement du transducteur de flexion piézoélectrique (4) en fonction des valeurs de mesure des essais de fonctionnement précédents.

13. Soupape de sécurité (1) selon l'une quelconque des revendications précédentes,
**caractérisée en ce que**
le transducteur de flexion piézoélectrique (4) est conçu en choisissant une géométrie appropriée et des matériaux adéquats de telle manière que la capacité électrique du transducteur de flexion piézoélectrique (4) est toujours inférieure à 170 nF, de préférence inférieure à 100 nF sur une gamme de températures de fonctionnement admise de - 40° C à + 80°C.

14. Soupape de sécurité (1) selon au moins l'une quelconque des revendications précédentes, en particulier selon la revendication 5 et la revendication 13,
**caractérisée en ce que**
le niveau préliminaire électro-fluidique (2) est constitué selon la DIN EN 60079-11 pour utilisation dans des atmosphères explosives, de préférence sous la forme d'une unité exécutée de façon intrinsèque.

15. Soupape de sécurité (1) selon au moins l'une quelconque des revendications précédentes, **caractérisée en ce que** l'unité de commande (2) comporte une interface pour la communication avec des dispositifs et systèmes de commande, de régulation, de diagnostic et/ou de communication supérieurs et est agencée pour la transmission active ou passive de données déterminées pendant les essais de fonctionnement itératifs.
